# EUROPÄISCHE PATENTSCHRIFT

(11) **EP 1 192 657 B1**
(45) Veröffentlichungstag und Bekanntmachung des Hinweises auf die Patenterteilung: **19.03.2003**
(21) Anmeldenummer: 00943860.7
(22) Anmeldetag: 21.06.2000
(51) Int. Cl.: H01L 21/782, H01L 21/68

(54) **VERFAHREN ZUM VEREINZELN EINES WAFERS**
METHOD OF SUBDIVIDING A WAFER
PROCEDE DE SEPARATION D'UNE PLAQUETTE

(30) Priorität: 01.07.1999 EP 99112540; 23.12.1999 DE 19962763
(43) Veröffentlichungstag der Anmeldung: 03.04.2002
(73) Patentinhaber: Fraunhofer-Gesellschaft zur Förderung der angewandten Forschung e.V., 80636 München (DE)
(72) Erfinder: FEIL, Michael, D-81475 München (DE); LANDESBERGER, Christof, D-81241 München (DE); KLUMPP, Armin, D-80337 München (DE); HACKER, Erwin, D-87600 Kaufbeuren (DE)
(74) Vertreter: Schoppe, Fritz, Dipl.-Ing.
(86) Internationale Anmeldenummer: EP0005772
(87) Internationale Veröffentlichungsnummer: WO01003180

(56) Entgegenhaltungen:
- WO-A-99/25019
- US-A- 5 071 792
- US-A- 5 476 566
- US-A- 5 910 687
- PATENT ABSTRACTS OF JAPAN vol. 018, no. 080 (E-1505), 9. Februar 1994 (1994-02-09) & JP 05 291397 A (TOSHIBA CORP), 5. November 1993 (1993-11-05)

## Beschreibung

Die vorliegende Erfindung bezieht sich auf die Herstellung von integrierten Schaltungen und insbesondere auf ein Verfahren zum Vereinzeln eines Wafers, der eine Mehrzahl von einzelnen Schaltungsstrukturen aufweist, um sehr dünne Schaltungschips zu erhalten.

In letzter Zeit entsteht immer mehr der Bedarf nach dünnen Chips einerseits und nach hoher Flexibilität andererseits, um elektronische Schaltungschips in einer Vielzahl von Anwendungen einzusetzen. Die Forderung nach dünnen Schaltungschips ergibt sich einerseits aus immer komplexeren elektronischen Systemen, die aus einzelnen fertig prozessierten und von verschiedenen Herstellern verfügbaren Chips zusammengesetzt sein sollen, und die gleichzeitig auch für Hochfrequenz-Anwendungen tauglich sein sollen und zudem wenig Platz einnehmen sollen. Um den Preis des gesamten Systems gering zu halten, sollen solche Chips bzw. Module mit solchen Chips mittels üblicher preisgünstiger Herstellungsverfahren aufgebaut werden können.

Eine wesentliche Anforderung besteht insbesondere darin, für möglichst viele Anwendungen vorprozessierte Chips, die fertig erworben werden können, einsetzen zu können, um z. B. von einem einzelnen Chiphersteller unabhängig zu sein, oder aber um keine eigenen Chips entwickeln zu müssen, was in vielen Fällen den Preis erhöhen würde, sondern um sich lediglich auf die Verschaltung der einzelnen Chipkomponenten konzentrieren zu können, wenn ein neues System entwickelt wird. So haben Untersucheungen gezeigt, daß beispielsweise bei einfachen Silizium-Schaltungschips bis zu 90% der Wertschöpfung des späteren Produkts im Bereich der Aufbau- und Verbindungstechnik liegen, aber nicht bei der Herstellung des Wafers, aus dem durch Vereinzeln die einzelnen Schaltungschips erhalten werden können.

Somit muß auf vorprozessierte Wafer zurückgegriffen werden, um durch Vereinzeln die einzelnen Schaltungschips zu erhalten.

Das U.S.-Patent Nr. 4,722,130 beschreibt ein Verfahren zum Herstellen von Halbleiterchips durch Vereinzeln eines Halbleiterwafers. Hierzu wird ein gitterförmiger Graben in die Vorderseite des Wafers eingebracht, woraufhin eine einseitige Nylon-Klebefolie auf die Vorderseite des Wafers, in der der Graben gebildet ist, aufgebracht wird. Anschließend wird die Rückseite des Trägers abgeschliffen, um den Wafer bis zu einer bestimmten Dicke abzudünnen, wobei die Dicke des abgedünnten Wafers so gewählt ist, daß die einzelnen, durch die Gräben bereits festgelegten Schaltungschips über relativ dünne Verbindungsstege verbunden sind. Um die einzelnen durch Verbindungsstege verbundene Schaltungschips voneinander zu trennen, wird die Nylon-Klebefolie von einer Seite des Wafers aus abgezogen, was bewirkt, daß die Verbindungsstege zwischen den Schaltungschips aufgrund der Zugwirkung beim Abziehen der Klebefolie springen. Wenn die Klebefolie abgezogen ist, hängen die vereinzelten Chips noch auf einer elastischen Trägerfolie auf der gegenüberliegenden Seite des Chips, die vor dem Abziehen der Nylon-Klebefolie angebracht worden ist. Hierauf wird die elastische Klebefolie transversal auseinandergezogen, was bewirkt, daß die Zwischenräume zwischen den Schaltungschips aufgeweitet werden, was ohne weiteres möglich ist, da die Verbindungsstege bereits gesprungen sind. Dann können die einzelnen Schaltungschips abgenommen werden und an Ort und Stelle eingesetzt werden bzw. weiterverwendet werden. Derart produzierte Schaltungschips haben eine Dicke von etwa 160 µm, wobei von einem Standard-GaAs-Wafer ausgegangen wurde, der eine Dicke von 630 µm hatte, bevor er durch Schleifen abgedünnt wurde.

Nachteilig an diesem Verfahren ist, daß keine sehr dünnen und damit auch sehr empfindlichen Chips erzeugt werden können. Durch das mechanische Dünnen und durch das mechanische Vereinzeln der Chips durch Brechen der Verbindungsstege besteht die Gefahr, daß die einzelnen Chips mechanisch beschädigt werden bzw. rauhe bzw. sogar eingerissene Kanten haben. Solche Probleme sind bei 160 µm dicken Chips noch nicht sehr einschneidend. Sollen jedoch Chips mit einer Dicke kleiner als 50 µm und insbesondere mit einer Dicke von 20 um hergestellt werden, können solche Risse aufgrund der mechanischen Rückseitenbearbeitung und des mechanischen Brechens der Erfindungsstege zu hohen Produktionsausfällen führen, da aufgrund der sehr geringen Dicke ohne weiteres aktive Bereiche der Chips beeinträchtigt bzw. sogar zerstört werden können.

Die WO 99/25019 bezieht sich auf ein Verfahren zum Dünnen von Halbleiter-Wafern. Zunächst wird eine Mehrzahl von Rillen in der Vorderseite eines Halbleiterwafers definiert. Die Rillen trennen jede integrierte Schaltung in einen getrennten Chip. Die Rillen erstrecken sich nur teilweise in die Vorderseite. Nach dem Herstellen der Rillen wird eine Polyimidschicht aufgebracht, um eine Planarisierung des mit Rillen versehenen Wafers zu schaffen, und um als Spannungsausgleichsschicht für die nachfolgende Dünnungsoperation durch Schleifen zu dienen. Auf diese Polyimidschicht wird eine Klebstoffschicht durch Sprühen oder Aufschleudern aufgebracht. Der Wafer wird dann mit der Klebstoffschicht auf eine Oberfläche eines Substrats gelegt. Um den Wafer an dem Substrat zu befestigen, werden ein vorbestimmter Druck und eine vorbestimmte Temperatur angewandt, um die Klebstoffschicht auszuhärten. Hierauf wird der Wafer von der Rückseite her durch Schleifen gedünnt. Der gedünnte Wafer wird dann auf einen Nadelblock plaziert und in ein Lösungsmittel eingetaucht, um die Klebstoffschicht aufzulösen, um dann die einzelnen Chips von dem Nadelblock unter Verwendung einer Vakuumvorrichtung zu entfernen und in Chipträgern zu plazieren.

Das US-Patent 5,071,792 bezieht sich auf ein Verfahren zum Bilden extrem dünner integrierter Schaltungschips. Zunächst werden in der Vorderseite des Wafers Rillen erzeugt. Diese Rillen werden dann mit einem harten Material ausgefüllt, das als Schleifenstop wirkt. Dieses Material wird dann planarisiert und mit Wachs versehen, das eine vorübergehende Haftung zwischen einer Passivierungsbeschichtung und der planaren Oberfläche eines Zwischenträgers liefert. Hierauf wird die Rückseite des Wafers geschliffen, um eine Vereinzelung der Chips zu erreichen. Hierbei wirkt das relativ harte Material in den Rillen als Schleifstopp. Nach dem Schleifen wird das Schleifstoppmaterial aus den Rillen entfernt. Um schließlich die einzelnen Chips zu erreichen, wird der Wachsfilm geschmolzen.

Die Aufgabe der vorliegenden Erfindung besteht darin, einerseits ein preisgünstiges und andererseits ein dennoch zuverlässiges Verfahren zum Vereinzeln eines Wafers zu schaffen, um sehr dünnen Schaltungschips zu erhalten.

Diese Aufgabe wird durch ein Verfahren nach Patentanspruch 1 gelöst.

Der vorliegenden Erfindung liegt die Erkenntnis zugrunde, daß, um sehr dünne Schaltungschips zu erhalten, mechanische Effekte beim Vereinzeln des Wafers so weit als möglich eliminiert werden müssen. Damit kann die Gefahr der Schädigung der einzelnen Schaltungschips aufgrund mechanischer Effekte stark verringert werden. Bei der Herstellung von sehr dünnen Schaltungschips muß bedacht werden, daß der aktive Bereich eines Schaltungschips sich bereits einige Mikrometer in das Halbleitermaterial hinein erstrecken kann. Wenn an dünne Schaltungschips mit einer Dicke in der Größenordnung von 20 µm gedacht wird, so verbleiben lediglich weniger als 20 µm als "Trägersubstrat" für den aktiven Bereich des Schaltungschips. Erfindungsgemäß wird daher von dem Konzept des mechanischen Vereinzelns abgegangen, das beispielsweise durch Ritzen, Sägen oder Brechen von durch Gräben definierten dünnen Verbindungen, wie es im vorhergehenden ausgeführt worden ist, erreicht wird, und es wird eine Vereinzelung mittels Trockenätzen von der Waferrückseite durchgeführt.

Erfindungsgemäß wird ein Wafer, der eine Mehrzahl von Schaltungsstrukturen aufweist, derart vereinzelt, daß zunächst ein Graben zwischen zumindest zwei Schaltungsstrukturen definiert wird. Anschließend wird der Graben bis zu einer bestimmten Tiefe ausgeführt. Hierauf wird ein wieder lösbarer Zwischenträger auf der Seite des Wafers befestigt, in der der Graben ausgeführt ist. Dann wird der Wafer von der anderen Seite aus einer Trockenätzung unterzogen, bis die Gräben freigelegt sind. Dadurch ist eine Vereinzelung erreicht, bei der keine mechanischen Belastungen auf die Schaltungschips ausgeübt worden ist.

Wenn, wie es besonders bevorzugt wird, auch der Graben nicht mechanisch sondern ebenfalls durch Trockenätzen gebildet wird, so wird bei der gesamten Vereinzelung des Wafers überhaupt keine mechanische Belastung auf die einzelnen Schaltungschips ausgeübt. Dies führt dazu, daß auch sehr dünne Schaltungschips erzeugt werden können, ohne daß der Ausschuß besonders ansteigt.

Gemäß einem bevorzugten Ausführungsbeispiel wird der Wafer vor dem Trockenätzen der Rückseite beispielsweise mittels naßchemischem Ätzen oder Schleifen vorgedünnt, wobei das Vordünnen mittels mechanischer Mittel lediglich soweit ausgeführt wird, daß nahezu ausgeschlossen werden kann, daß bereits eine mechanische Beeinträchtigung des Materials aufgetreten ist, das schließlich die Schaltungschips bildet.

Als Zwischenträger wird eine zweiseitige Haftfolie verwendet, deren eine Seite an einem Wafersubstrat klebt, und deren andere Seite mit dem zu vereinzelnden Wafer verbunden ist und eine variable Haftkraft hat, so daß nach dem Trockenätzen lediglich beispielsweise durch Erwärmen oder durch Bestrahlen mit UV-Strahlung die Haftkraft dieser Seite der Klebefolie derart verringert werden kann, daß die vereinzelten Schaltungschips ohne weiteres gelöst werden können, um weiterverarbeitet zu werden.

Selbst wenn der Graben durch schonende mechanische Verarbeitungsverfahren ausgeführt wird, kann bereits aufgrund des Trockenätzens von der Rückseite aus, um den Wafer zu vereinzeln, eine Mehrzahl von Schaltungschips mit relativ geringer Ausschußrate erzeugt werden. Solche Schaltungschips können eine Dicke haben, die kleiner als 50 µm ist und insbesondere bei 20 µm liegt und sogar auf bis zu 5 µm reduziert werden kann.

Wenn jedoch, wie es bevorzugt wird, auch der Graben durch Trockenätzen, also sehr materialschonend, erzeugt wird, so ergeben sich noch einige weitere Vorteile, indem überhaupt keine mechanischen Belastungen auf die Bereiche des Wafers ausgeübt werden, die schließlich die dünnen Schaltungschips ergeben.

Generell ist das Ausführen des Grabens unter Verwendung einer Maske für das Ätzen aufgrund der Tatsache, daß der Graben nicht besonders tief zu sein braucht, da die Chips sehr dünn sind, relativ schnell, so daß im Vergleich zum Sägen eines Wafers, das insbesondere bei kleinen Chips und Scheiben mit einem Durchmesser von 20 bis 30 cm bis zu mehrere Stunden dauern kann, eine wesentliche Durchsatzerhöhung erreichbar ist. Darüberhinaus passen ebenfalls im Vergleich zum Sägen insbesondere bei kleinen Chips wesentlich mehr Chips auf einen Wafer, da Sägegräben im allgemeinen eine Dicke von etwa 100 µm haben, während für trockengeätzte Gräben bis zu der angestrebten Tiefe, die in etwa der Dicke der Schaltungschips entsprechen wird, lediglich 10 µm benötigt werden. Insbesondere bei kleinen Chips kann die Chipanzahl pro Wafer um bis zu 10 bis 15% gesteigert werden.

Die Chips sind aufgrund der Ätzbehandlung zumindest ihrer Rückseite und vorzugsweise auch ihrer Seitenkanten mechanisch integer, was besonders dann wichtig ist, wenn die Chips gebogen werden müssen, wie es beispielsweise der Fall sein kann, wenn sie in elektronischen Etiketten eingesetzt werden müssen.

Schließlich sind insbesondere durch Trockenätzen des Grabens beliebige Chipformen möglich, also nicht nur rechteckige Formen, wie es beim Sägen der Fall ist, was besonders für Leistungshalbleiter entscheidend sein kann, da Chipecken eliminiert werden können, welche ansonsten sehr hohe elektrische Felder erzeugen. Schließlich kann auch die Lage der Chips von hinten eindeutig identifiziert werden, was z. B. beim Die-Bonden und beim Erkennen von guten und schlechten Chips von großem Vorteil sein wird.

Bevorzugte Ausführungsbeispiele der vorliegenden Erfindung werden nachfolgend bezugnehmend auf die beiliegenden Zeichnungen detailliert erläutert. Es zeigen:
- Fig. 1: eine Draufsicht auf einen Wafer mit einer Mehrzahl von Schaltungschips, in dem ein Graben definiert ist;
- Fig. 2: eine Querschnittsansicht des Wafers von Fig. 1, in dem der Graben ausgeführt ist;
- Fig. 3: eine Ansicht des Wafers von Fig. 2, der an einem zwischenträger befestigt ist;
- Fig. 4: eine Ansicht des Wafers von Fig. 3 nach dem Dünnen des Wafers unter Verwendung eines Trockenätzverfahrens; und
- Fig. 5: die einzelnen Schaltungschips, nachdem sie vom Zwischenträger entfernt worden sind.

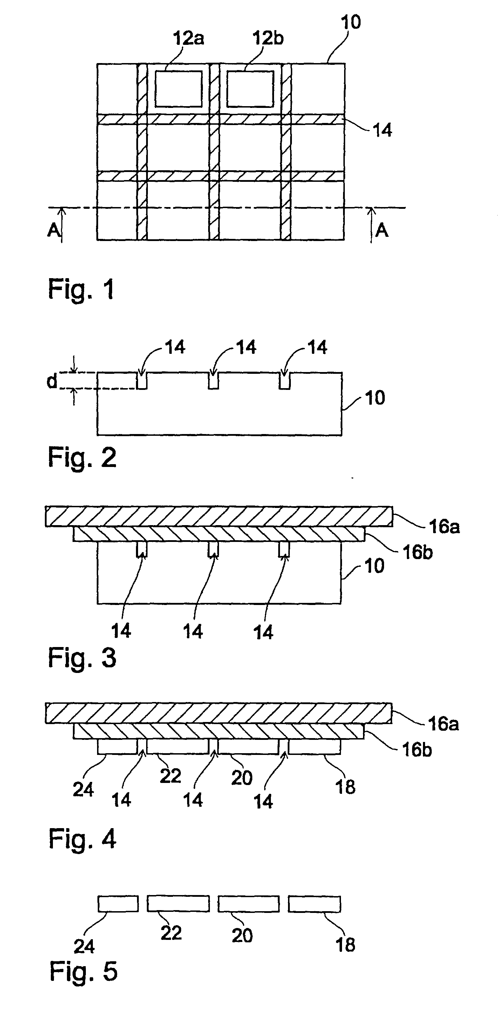

Fig. 1 zeigt eine Draufsicht auf einen Ausschnitt eines Wafers 10, der eine Mehrzahl von fertig prozessierten einzelnen Schaltungsstrukturen 12a, 12b aufweist. Auf dem Wafer 10 ist bereits ein Graben 14 definiert. Das Definieren des Grabens kann beispielsweise im Falle des mechanischen Erzeugens des Grabens 14 durch Eingeben der Koordinaten für eine Sägeoder eine Ritzeinrichtung stattfinden. Im Falle des Erzeugens des Grabens 14 unter Verwendung eines Trockenätzverfahrens wird der Graben durch Aufbringen einer Lackmaske mit Seitenwandschutz durch Polymerabscheidung gebildet. Alternativ kann die Ätzmaske, die den Graben 14 definiert, auch als SiO₂-Maske ausgeführt sein. Zusammenfassend können sämtliche Verfahren zum Bilden einer Ätzmaske eingesetzt werden, um den Graben 14 zu definieren.

Fig. 2 zeigt eine Querschnittsdarstellung entlang der Linie A-A von Fig. 1 durch den Wafer 10, nachdem der Graben 14 bis zu einer bestimmten Tiefe d ausgeführt ist. Die vorbestimmte Dicke wird zumindest gleich der Zieldicke des herzustellenden Schaltungschips gewählt, so daß die Schaltungschips später ohne mechanische Einwirkungen vereinzelt werden können.

Wird beispielsweise der Prozeß mit Polymerabscheidung eingesetzt, so kann als Ätzgas SF₆ und als Polymerschutz CHF₃ und C₂F₆ eingesetzt werden. Nähere Einzelheiten zu diesem Verfahren sind in der DE 4241045 offenbart.

Wird ein Prozeß mit einer SiO₂-Maske eingesetzt, so kann als Ätzgas ein Gemisch aus HBr, Cl₂, O₂ und He eingesetzt werden. Darüberhinaus können sämtliche anderen bekannten Trockenätzverfahren eingesetzt werden. Das Trockenätzen allgemein hat den wesentlichen Vorteil, daß die Ränder der Schaltungschips im Gegensatz zu einer mechanischen Ausführung des Grabens nicht mechanisch beansprucht werden und somit stabil sind.

Fig. 3 zeigt den mit dem Graben 14 versehenen Schaltungschip 10, nachdem er an einem Zwischenträger befestigt ist, der sich aus einem Substratwafer 16a und aus einem Haftmedium 16b zusammensetzen kann. Als Haftmedium 16b wird eine beidseitig haftende Klebefolie eingesetzt, deren eine Seite eine spezielle Beschichtung hat, die nach Erwärmung auf beispielsweise 90 bis 140°C ihre Haftkraft verliert. Die andere Seite hat dabei keine variierende Haftkraft. Die Trägerfolie wird derart angebracht, daß die Seite mit der nicht-variierenden Haftkraft mit dem Waferträger 16a verbunden ist, während die Seite mit variierender Haftkraft mit dem Halbleiterwafer 10 verbunden wird, wie es in Fig. 3 gezeigt ist. Eine wesentliche Eigenschaft des Zwischenträgers 16a, 16b besteht darin, daß die Klebeverbindung mit dem Wafer 10 wieder gelöst werden kann. Ferner ist eine vollflächige lunkerfreie Verbindung von Vorteil.

Alternative Materialien für das Haftmedium 16b sind Klebefolien, deren Haftkraft nicht durch Wärme, sondern durch UV-Licht variierbar ist. Falls UV-lichtempfindliche Folien eingesetzt werden, so muß das Trägersubstrat 16a transparent sein. In diesem Falle kann als Trägersubstrat ein Glaswafer zum Einsatz kommen.

Nach dem Aufkleben des Wafers 10 an dem Zwischenträger 16a, 16b wird der Wafer, wie es in Fig. 4 gezeigt ist, von der Rückseite her gedünnt. Falls der Ausgangswafer 10 bereits relativ dünn ist, so dürfte es ausreichend sein, daß lediglich ein Trockenätzverfahren eingesetzt wird, um die einzelnen Schaltungschips voneinander zu trennen, d. h. um die Rückseite mindestens bis zum Graben zu entfernen. Liegt jedoch ein dicker Wafer beispielsweise mit einer Dicke von 700 µm vor, was für käufliche Wafer ein typischer Wert ist, so wird es bevorzugt, vor dem abschließenden Trockenätzschritt zum Vereinzeln der Schaltungschips ein schnelleres Verfahren einzusetzen, wie z. B. mechanisches Schleifen, Naßätzen oder ähnliches. Ein Verfahren, das sich als vorteilhaft herausgestellt hat, ist das sogenannten Spin-Ätzen. Hier liegt der Wafer auf einem rotierenden Teller, während von oben das Ätzmedium auf die Scheibe fließt und von dort abgeschleudert wird.

Ist der Wafer dann auf eine vorbestimmte Dicke vorgedünnt, so verbleibt der letzte Schritt des Vereinzelns dem Trockenätzverfahren. Hierzu wird es bevorzugt, das Ätzgasgemisch Cl₂ und CF₄ oder als alleiniges Ätzgas SF₆ einzusetzen. Es sei angemerkt, daß generell zum Ätzen von Silizium eine Chlor- und Fluor-Chemie gut geeignet ist. Das Ätzgas NF₃ ist ebenfalls sehr wirksam, hat jedoch derzeit noch einen relativ hohen Preis und wird daher derzeit weniger bevorzugt.

Wie es in Fig. 4 gezeigt ist, sind nun einzelne Schaltungschips 18, 20, 22 und 24 entstanden, welche nicht mehr miteinander in Verbindung stehen sondern lediglich durch das Haftmedium 16b gehalten werden. Im Falle einer Verwendung der zweiseitig klebende Folie mit einer Seite mit variabler Haftkraft können die einzelnen Schaltungschips 18, 20, 22, 24 nun ohne weiteres durch Verändern der Haftkraft entfernt werden, um dann, wie es in Fig. 5 gezeigt ist, völlig unabhängig voneinder vorzuliegen, um dann von einer Bestückungsmaschine oder einer ähnlichen Vorrichtung aufgenommen zu werden, um an ihrem letztendlichen Bestimmungsort untergebracht zu werden.

Es sei darauf hingewiesen, daß dieses Verfahren nicht nur für Siliziumwafer geeignet ist, sondern auch für GaAs-Wafer, welche aufgrund ihrer Sprödigkeit mechanisch besonders anfällig sind, sowie für andere III-V-Halbleiter. Selbstverständlich werden für andere Halbleitermaterialien als Silizium auch andere Ätzgase als die genannten eingesetzt.

Die vereinzelten dünnen Schaltungschips 18, 20, 22, 24 können in elektronischen Bauteilen und Systemen eingesetzt werden, welche einen extrem geringen Volumenbedarf erfordern, wie z. B. in mobilen Telekommunikationssystemen oder in medizinischen Überwachungs- und Hilfssystemen, wie Hörgeräten, Herzschrittmachern, am Körper getragenen Überwachungs- und Diagnosegeräten, usw.

Andere Einsatzmöglichkeiten sind elektronische Bauteile, welche für eine elektrische Signalübertragung optimiert sind, wie z. B. Hochfrequenzbauelemente.

Schließlich können die erfindungsgemäß vereinzelten dünnen Schaltungschips zu Schaltungsmodulen kombiniert werden, welche Einzelkomponenten aus unterschiedlichen Grundmaterialien umfassen, oder bei denen Chips aus unterschiedlichen Fertigungstechnologien zusammengesetzt sind. Superdünne Schaltungschips können besonders bei Systemen aus Speicher-Chips, Logik-Chips, Sensorbauelementen, Chipkarten-Chips, Leistungsbauelementen oder Hochfrequenzübertragungschips (Transponder) zum Einsatz kommen.

Erfindungsgemäß erzeugte dünne Schaltungschips tragen aufgrund ihrer sehr geringen Dünne nur als dünner Film zum gesamten Bauelementevolumen bei. Ein komplettes Chipsystem, das beispielsweise aus einem normalen Chip und einem superdünnen Chip besteht, ist letztendlich nicht wesentlich größer als ein üblicher integrierter Schaltkreis.

Aufgrund der geringen Dicke der vereinzelten Schaltungschips können nun auch Oberflächenbearbeitungstechniken zur Kontaktierung und Verdrahtung einzelner Chips in einem Multi-Chip-Modul unter Verwendung üblicher Techniken eingesetzt werden, die plane bzw. nahezu plane Oberflächen erfordern.

Schließlich können mit dem erfindungsgemäßen Verfahren nicht nur speziell hergestellte bzw. vorbearbeitete Schaltungswafer vereinzelt werden, sondern sämtliche Wafer, welche fertigprozessiert von beliebigen Herstellern erworben werden können.

## Patentansprüche

1. Verfahren zum Vereinzeln eines Wafers (10), der eine Mehrzahl von Schaltungsstrukturen (12a, 12b) aufweist, mit folgenden Schritten:
Definieren eines Grabens (14) zwischen zumindest zwei Schaltungsstrukturen (12a, 12b) auf einer Seite des Wafers (10);
Ausführen des Grabens (14) bis zu einer bestimmten Tiefe (d) durch Trockenätzen;
Befestigen eines wieder lösbaren Zwischenträgers (16a, 16b), der aus einem festen Zwischenträgersubstrat (16a) und einem auf diesem aufgebrachten, in seiner Haftkraft gezielt veränderbaren Haftmedium (16b) besteht, an der einen Seite des Wafers (10), wobei das Haftmedium (16b) eine beidseitig haftende Haftfolie ist, wobei die Seite der Haftfolie, die an der einen Seite des Wafers befestigt ist, die veränderbare Haftkraft aufweist, und wobei die Haftkraft durch Erwärmen oder durch Einwirkung von UV-Licht reduziert werden kann;
Dünnen des an dem Zwischenträger (16a, 16b) befestigten Wafer von der anderen Seite aus durch Trockenätzen, um einzelne Schaltungschips (18, 20, 22, 24) zu erhalten, die durch den Zwischenträger (16a, 16b) gehalten werden; und
Entfernen der einzelnen Schaltungschips (18, 20, 22, 24) von dem Zwischenträger (16a, 16b) durch Erwärmen des Zwischenträgers (16a, 16b) oder durch Einwirkung von UV-Licht auf die Haftfolie, um deren Haftkraft zu verringern, bis die Schaltungschips (18, 20, 22, 24) von dem Zwischenträger gelöst werden können.

2. Verfahren nach Anspruch 1, bei dem der Schritt des Trockenätzens der anderen Seite des Wafers (10) so lange ausgeführt wird, bis die Schaltungschips eine Dicke haben, die kleiner als 50 µm ist und vorzugsweise 20 µm beträgt.

3. Verfahren nach Anspruch 1,
bei dem das Ausführen des Grabens derart durchgeführt wird, daß eine vorbestimmte Tiefe erreicht ist, die gleich einer Ziel-Chipdicke ist; und
bei dem der Schritt des Trockenätzens der anderen Seite des Wafers so lange ausgeführt wird, bis der Graben im wesentlichen erreicht ist.

4. Verfahren nach einem der vorhergehenden Ansprüche,
bei dem vor dem Schritt des Trockenätzens der anderen Seite des Wafers (10) ein Schritt des Vordünnens ausgeführt wird, derart, daß die Schaltungschips noch über den Graben (14) hinweg miteinander verbunden sind und die Dicke dieser Verbindung einen bestimmten Wert hat.

5. Verfahren nach Anspruch 5, bei dem der Schritt des Vordünnens das Schleifen, das naßchemische Ätzen oder eine Kombination derselben aufweist.

6. Verfahren nach einem der Ansprüche 1 bis 5, bei dem im Schritt des Definierens des Grabens ein Graben mit zumindest einem runden Abschnitt definiert wird.

7. Verfahren nach einem der vorhergehenden Ansprüche, bei dem der Wafer aus Si, GaAs oder einem anderen III-V-Halbleiter besteht.

8. Verfahren nach einem der Ansprüche 1 bis 7, bei dem der Schritt des Definierens das Aufbringen einer SiO2-Maske oder einer Lackmaske mit Seitenwandschutz durch Polymerabscheidung aufweist.

## Claims

1. A method of dicing a wafer (10) which comprises a plurality of circuit structures (12a, 12b), said method comprising the steps of:
defining a trench (14) between at least two circuit structures (12a, 12b) on one face of the wafer (10);
forming the trench (14) down to a defined depth (d) by means of dry etching;
fixing to said one face of the wafer (10) a re-detachable intermediate support (16a, 16b) composed of a fixed intermediate support substrate (16a) and an adhesive medium (16b) which is applied to said intermediate support substrate and which can specifically be modified in terms of its adhesive strength, said adhesive medium (16b) being an adhesive foil which is adherent on both sides, the side of the adhesive foil which is secured to said one face of the wafer having the variable adhesive strength, and said adhesive strength being adapted to be reduced by heating;
thinning the wafer, which is secured to the intermediate support (16a, 16b), from the opposite face by means of dry etching so as to obtain individual circuit chips (18, 20, 22, 24) which are held by the intermediate support (16a, 16b); and
removing the individual circuit chips (18, 20, 22, 24) from the intermediate support (16a, 16b) by heating said intermediate support (16a, 16b) so as to reduce the adhesive strength of said adhesive foil (16b) to such an extent that the circuit chips (18, 20, 22, 24) can be detached from the intermediate support.

2. A method according to claim 1, wherein the dry-etching step of the other face of the wafer (10) is executed until the circuit chips have a thickness which is smaller than 50 µm and which is preferably 20 µm.

3. A method according to claim 1,
wherein the forming of the trench is carried out such that a predetermined thickness is reached, which corresponds to a target chip thickness; and
wherein the step of dry-etching the other face of the wafer is executed until the trench has substantially been reached.

4. A method according to one of the preceding claims,
wherein, prior to the step of dry etching the other face of the wafer (10), a pre-thinning step is executed in such a way that the circuit chips are still interconnected across the trench (14) and that the thickness of this connection has a specific value.

5. A method according to claim 4, wherein the pre-thinning step comprises grinding, wet-chemical etching or a combination thereof.

6. A method according to one of the claims 1 to 5, wherein in the trench-defining step a trench having at least one round portion is defined.

7. A method according to one of the preceding claims, wherein the wafer consists of Si, GaAs or some other III-V semiconductor.

8. A method according to one of the claims 1 to 7, wherein the defining step comprises the application of an SiO₂ mask or of a resist mask with side-wall protection by polymer deposition.

## Revendications

1. Procédé de séparation d'une plaquette (10) présentant une pluralité de structures de circuit (12a, 12b), aux étapes suivantes consistant à :
définir une fosse (14) entre au moins deux structures de circuit (12a, 12b) d'un côté de la plaquette (10);
réaliser la fosse (14) jusqu'à une profondeur déterminée (d), par gravure à sec ;
fixer, d'un côté de la plaquette (10), un support intermédiaire (16a, 16b) amovible composé d'un substrat de support intermédiaire fixe (16a) et d'un matériau adhésif (16b) appliqué sur ce dernier et variable de manière visée en ce qui concerne sa force d'adhérence, le matériau adhésif (16b) étant un film adhésif double face, le côté du film adhésif fixé d'un côté de la plaquette présentant la force d'adhérence variable et la force d'adhérence pouvant être diminuée par échauffement ou sous l'action de lumière ultraviolette ;
amincir la plaquette fixée au support intermédiaire (16a, 16b) par gravure en sec depuis l'autre côté, pour obtenir des puces à circuit (18, 20, 22, 24) individuelles portées par le support intermédiaire (16a, 16b) ; et
enlever les puces à circuit (18, 20, 22, 24) individuelles du support intermédiaire (16a, 16b) par échauffement du support intermédiaire (16a, 16b) ou sous l'action de lumière ultraviolette sur le film adhésif, pour diminuer sa force d'adhérence jusqu'à ce que les puces à circuit (18, 20, 22, 24) puissent être détachées du support intermédiaire.

2. Procédé selon la revendication 1, dans lequel l'étape de gravure en sec de l'autre côté de la plaquette (10) est réalisée jusqu'à ce que les puces à circuit aient une épaisseur qui est inférieure à 50 µm et qui est, de préférence, de 20 µm.

3. Procédé selon la revendication 1,
dans lequel la réalisation de la fosse s'effectue de telle sorte qu'il soit atteint une profondeur prédéterminée qui est égale à une épaisseur de puce visée : et
dans lequel l'étape de gravure en sec de l'autre côté de la plaquette s'effectue jusqu'à ce que la fosse soit substantiellement obtenue.

4. Procédé selon l'une des revendications précédentes, dans lequel s'effectue, avant l'étape de gravure en sec de l'autre côté de la plaquette (10), une étape de pré-amincissement, de sorte que les puces à circuit soient encore assemblées l'une à l'autre, par-dessus la fosse (14), et que l'épaisseur de cette connexion ait une valeur déterminée.

5. Procédé selon la revendication 5, dans lequel l'étape de pré-amincissement présente le polissage, la gravure chimique humide ou une combinaison de ceux-ci.

6. Procédé selon l'une des revendications 1 à 5, dans lequel est définie, à l'étape de définition de la fosse, une fosse avec au moins un segment rond.

7. Procédé selon l'une des revendications précédentes, dans lequel la plaquette est en Si, GaAs ou un autre semi-conducteur III-V.

8. Procédé selon l'une des revendications 1 à 7, dans lequel l'étape de définition présente l'application d'un masque de SiO₂ ou d'un masque de laque avec protection de la paroi latérale par dépôt de polymère.
